# FASCICULE DE BREVET EUROPEEN

(11) **EP 0 424 205 B1**
(45) Date de publication et mention de la délivrance du brevet: **08.06.1994**
(21) Numéro de dépôt: 90402745.5
(22) Date de dépôt: 04.10.1990
(51) Int. Cl.: H01R 31/02, H05K 7/18, G01F 19/00

(54) **Chaîne de liaison électrique pour unités périphériques de système de traitement de l'information**
Elektrische Kabelkette für periphere Einheiten eines Informationsverarbeitungssystems
Electrical connecting chain for peripheral information treatment system unities

(30) Priorité: 06.10.1989 FR 8913111
(43) Date de publication de la demande: 24.04.1991
(73) Titulaire: BULL S.A., 92800 Puteaux (FR)
(72) Inventeur: Carteau, Daniel, F-91470 Limours (FR)
(74) Mandataire: Gouesmel, Daniel

(56) Documents cités:
- EP-A- 0 093 398
- DE-A- 2 252 393
- DE-A- 2 545 485
- DE-B- 2 140 376

## Description

La présente invention concerne une chaîne de liaison électrique pour unités périphériques de système de traitement de l'information. Elle est plus particulièrement adaptée pour relier entre elles des unités de mémoires à disques.

Les systèmes de traitement de l'information modernes sont de plus en plus complexes. Ils se composent d'un système central occupant une position géographique déterminée, autour duquel gravitent des systèmes secondaires (ou encore systèmes satellites) qui sont localisés en des endroits géographiques différents de celui occupé par le système central, distants de quelques kilomètres à quelques centaines voire parfois quelques milliers de kilomètres. La structure d'un système, qu'il soit central ou secondaire, est faite d'une unité centrale reliée à différents organes périphériques, parmi lesquels se trouvent les mémoires magnétiques de masse, à savoir mémoires à disques ou mémoires à bandes magnétiques. Le rôle des mémoires magnétiques de masse, en particulier des mémoires à disques est de stocker les informations destinées à être traitées par le système de traitement de l'information (dans son ensemble, systèmes central et secondaire) lorsqu'un usager situé en lieu géographique quelconque en fait la demande.

Dans chaque système (central ou secondaire) les mémoires à disques sont commandées par un contrôleur de mémoire disposé entre l'unité centrale du système correspondant et les mêmes mémoires, sa fonction essentielle étant de commander le flux des informations qui transitent des mémoires vers l'unité centrale et réciproquement.

Le contrôleur et les mémoires sont reliés entre eux par une chaîne de liaison électrique

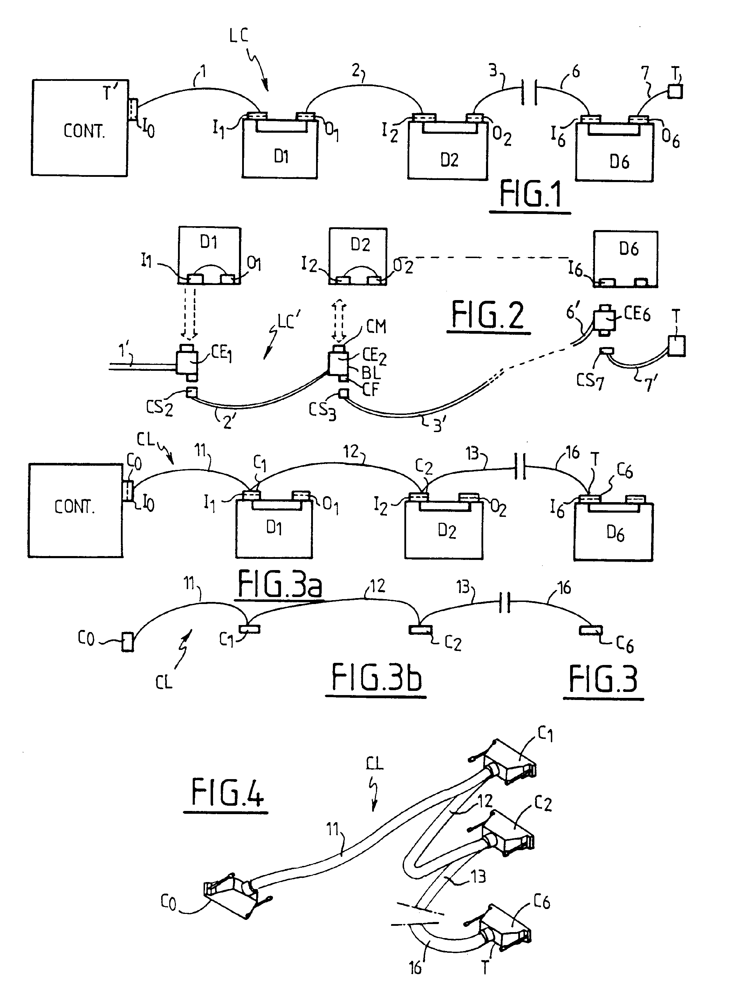

Dans la pratique courante, la structure d'une telle chaîne de liaison est, par exemple, celle montrée à la figure 1, et qui est désignée par LC. Elle relie entre eux, le contrôleur de mémoires à disques CONT, et les différentes mémoires à disques D₁, D₂, D₆.

Chacune des mémoires à disques comprend un connecteur d'entrée et un connecteur de sortie. Ainsi, la mémoire à disques D₁ comprend un connecteur d'entrée I₁ et un connecteur de sortie O₁, la mémoire à disques D₂, un connecteur d'entrée I₂ et un connecteur de sortie O₂, la mémoire à disques D₆ comprenant un connecteur d'entrée I₆ et un connecteur de sortie O₆. Dans chaque mémoire à disques, le connecteur d'entrée est relié, à l'intérieur de celle-ci, au connecteur de sortie. Le contrôleur CONT comprend un connecteur de sortie I₀. Tous les connecteurs d'entrée I₁ à I₆ , sont, par exemple, des connecteurs femelles, alors que tous les connecteurs de sortie O₁ à O₆ sont des connecteurs mâles (ou réciproquement).

La liaison chaînée selon l'art antérieur, LC, comprend une pluralité de liaisons individuelles 1 à 6, la liaison 1 reliant le contrôleur CONT à la mémoire à disques D₁, par l'intermédiaire des connecteurs I₀ et I₁, la liaison 2 reliant entre elles les mémoires à disques D₁ et D₂, par l'intermédiaire des connecteurs O₁ et I₂, et ainsi de suite, la liaison 6 reliant entre elles les mémoires à disques D₅ et D₆ par l'intermédiaire des connecteurs O₅ et I₆. Par ailleurs, le connecteur de sortie O₆ de la mémoire à disques D₆ est relié à un terminateur T, par l'intermédiaire d'une liaison 7. De même, le contrôleur CONT contient, en interne, un terminateur T′ qui est relié au connecteur I₀. Le rôle des terminateurs T et T′ est de réaliser l'adaptation d'impédance entre les différentes mémoires à disques D₁ à D₆ et le contrôleur CONT. Ces terminateurs sont, de façon connue, constitués d'un réseau de résistance à composants discrets ou d'un ensemble hybride constitué de résistances en couches épaisses montées sur un circuit imprimé.

Chacune des liaisons 1 à 6 est, soit de type SCSI, soit de type IPI. Chacun de ces deux types de liaisons est défini par des normes de l'ANSI (American National Standards Institute). Ces normes définissent la mécanique, la connectique, le câble avec ses différentes caractéristiques (électriques, mécaniques) ainsi que les différents niveaux de tension, les temps de montée, etc, des différents signaux transitant entre les différentes mémoires à disques et le contrôleur. Chaque liaison, également appelée liaison d'interface, est différentielle (ceci est également défini par les normes précitées). Physiquement, une liaison telle que 1 à 6, se présente sous la forme d'un câble constitué d'une gaine à l'intérieur de laquelle sont situées 25 paires torsadées, le câble étant muni à sa première extrémité d'un connecteur mâle (50 points) et à sa seconde extrémité d'un connecteur femelle (50 points). Lorsque l'on retire une mémoire à disques de la chaîne, D₂ par exemple, ceci permet, après avoir déconnecté les câbles 2 et 3 des connecteurs I₂ et O₂, de connecter ces câbles entre eux par l'intermédiaire de leurs connecteurs mâle et femelle rendus libres par cette déconnexion.

Les exigences du développement économique et la croissance rapide des différents moyens de télécommunications ont pour corollaire une complexité de plus en plus grande des systèmes de traitement de l'information tels que définis plus haut : ceux-ci intègrent toujours davantage de fonctions différentes, le nombre d'usagers augmente, ainsi que le nombre de sites où sont situés les systèmes secondaires. Par ailleurs, le nombre d'éléments de chacun des systèmes secondaires et du système central augmente. Parallèlement, l'usager exige désormais que les données qu'il veut utiliser ou dont il a besoin soient disponibles immédiatement. Par conséquent, l'indisponibilité des données est de plus en plus difficilement tolérée. Si on interrompt, pour une raison quelconque l'accès à une mémoire à disques quelconque, il est nécessaire que cette interruption ne cause pas d'interruption simultanée sur les autres mémoires à disques, à laquelle celle-ci est reliée par l'intermédiaire d'une chaîne de liaison. C'est précisément l'inconvénient des chaînes de liaison selon l'art antérieur montrées à la figure 1. En effet, on voit aisément, sur cette même figure, que, le retrait de l'une des mémoires à disques, par exemple D₂, (pour une raison quelconque, soit une panne, soit une opération de maintenance sur celles-ci, soit le retrait des disques qui y sont contenus et leur remplacement par d'autres, etc) provoque une interruption physique de la chaîne de liaison LC, qui entraîne l'indisponibilité de fait, des autres mémoires à disques D₁ et D₃ à D₆. Si un usager a, pendant ce temps, besoin d'avoir accès aux données qui sont contenues sur ces dernières, il est obligé d'attendre que la chaîne de liaison LC soit rétablie dans son intégralité physique, c'est -à-dire que l'on connecte à nouveau la mémoire à disques D₂, ou que l'on connecte directement la mémoire à disques D₃ à la mémoire à disques D₁.

La chaîne de liaison LC montrée à la figure 1 ne satisfait donc pas les exigences de disponibilité des systèmes de traitement de l'information complexes.

La chaîne de liaison LC′ montrée partiellement à la figure 2 permet de remédier en partie aux inconvénients mentionnés ci-dessus.

La chaîne LC′ contient une pluralité d'éléments physiquement indépendants tels que 1′,2′,3′. Seul l'élément 2′ est montré dans son intégralité à la figure 2. Il comprend un câble de liaison 20 comprenant 25 paires torsadées, ses extrémités étant munies respectivement d'un connecteur de sortie CS₂ et d'un connecteur d'entrée CE₂. Ces deux derniers connecteurs sont structurellement distincts. Le connecteur CS₂ est un connecteur mâle 50 points, analogue au connecteur mâle de la première extrémité des éléments 1 à 6 de la chaîne de liaison LC de la figure 1, alors que le connecteur CE₂ est un boîtier plus complexe comprenant d'une part un connecteur mâle CM connecté au connecteur femelle I₂ de la mémoire à disques D₂ et d'autre part d'un connecteur femelle CF destiné à être connecté au connecteur mâle CS₃ de l'élément 3′. Les connecteurs mâle et femelle CM et CF du connecteur CE₂ sont reliés mécaniquement et électriquement par la boîte de liaison BL.

La chaîne de liaison LC′ est par exemple utilisée par le constructeur IMPRIMIS (anciennement CONTROL DATA) dans son sous-système de mémoire de masse MDS₁.

On voit que la chaîne de liaison LC′ de la figure 2 permet le retrait d'une mémoire à disques, par exemple D₁, sans que cela affecte la liaison entre le contrôleur et les autres mémoires à disques D₂ à D₆. L'usager qui utilisait les données contenues sur l'une de ces dernières mémoires n'est donc pas affecté par le retrait de D₁. Par contre, il est évident que si l'on veut ajouter une mémoire à disques, par exemple, D₇, à l'ensemble des mémoires D₁ à D₆, il est nécessaire de rompre la chaîne de liaison, par exemple au niveau de la mémoire à disques D₂ en déconnectant les connecteurs mâles CS₃ et CF, afin de permettre l'insertion de la mémoire D₇. Il en serait de même si l'on voulait ajouter la mémoire D₇ au bout de la chaîne. En effet, dans ce cas, il est nécessaire de déconnecter l'élément 7′ qui relie la dernière mémoire D₆ au terminateur T, afin d'y insérer la mémoire D₇.

Par ailleurs, la chaîne de liaison LC′ présente un autre inconvénient du fait qu'elle est composée d'une succession d'un grand nombre de connecteurs, ce qui a un impact sur la fiabilité électrique de l'ensemble et la qualité de la liaison, car cela introduit de nombreuses résistances de contact. Cela nécessite en outre la présence de nombreux blindages et il est nécessaire de respecter la continuité des masses électriques.

Enfin, la chaîne LC′ constitue un ensemble lourd et relativement cher.

Une autre chaîne de liaison électrique est connue du brevet DE-A-2.252.393 permettant l'adjonction ou la suppression p.ex. d'une unité de mémoire à disques (ou plus généralement d'une quelconque unité périphérique) sans arrêter le fonctionnement des autres unités de la chaîne (ce qui est appelé rupture de chaîne), ni même perturber le fonctionnement des autres unités de celles-ci. La chaîne de liaison selon l'invention n'est jamais interrompue, que ce soit mécaniquement ou électriquement, que l'on enlève ou que l'on rajoute une unité périphérique à la chaîne.

Selon l'invention telle que définie dans la revendication 1, la chaîne de liaison électrique reliant entre elles une pluralité de au maximum n organes périphériques et leur contrôleur associé, comprend une suite de n câbles distincts à plusieurs paires torsadées et un ensemble d'éléments de connexion à plusieurs points permettant de relier électriquement entre eux les câbles et d'y connecter les organes périphériques, et des terminateurs d'adaptation d'impédance placés aux deux extrémités de la chaîne, la chaîne formant un ensemble mécanique unique, chaque câble de la suite étant solidaire mécaniquement de son voisin au moyen d'un ensemble de connexion, chaque ensemble de connexion étant associé à une unité périphérique, l'un des deux terminateurs étant intégré à l'ensemble de connexion de l'extrémité de la chaîne opposée à l'extrémité raccordée au contrôleur.

L'invention concerne également une mémoire de masse magnétique, définie dans la revendication 2, comprenant une pluralité d'unités amovibles de mémoires magnétiques disposées à l'intérieur d'au moins une armoire qui comporte d'une part une pluralité de logements destinés chacun à recevoir une unité de mémoire, cette mémoire de masse comprenant également au moins une chaîne de liaison électrique selon la revendication 1 fixée sur le bâti de l'armoire au voisinage immédiat des logements des unités de mémoire de façon que chacun des éléments de connexion de la chaîne soit placé au niveau des connecteurs correspondants de l'unité de mémoire, de manière à y être connecté.

Un mode d'emploi de l'invention est exposé dans la description suivante donnée à titre d'exemple non limitatif et en se référant aux dessins annexés.

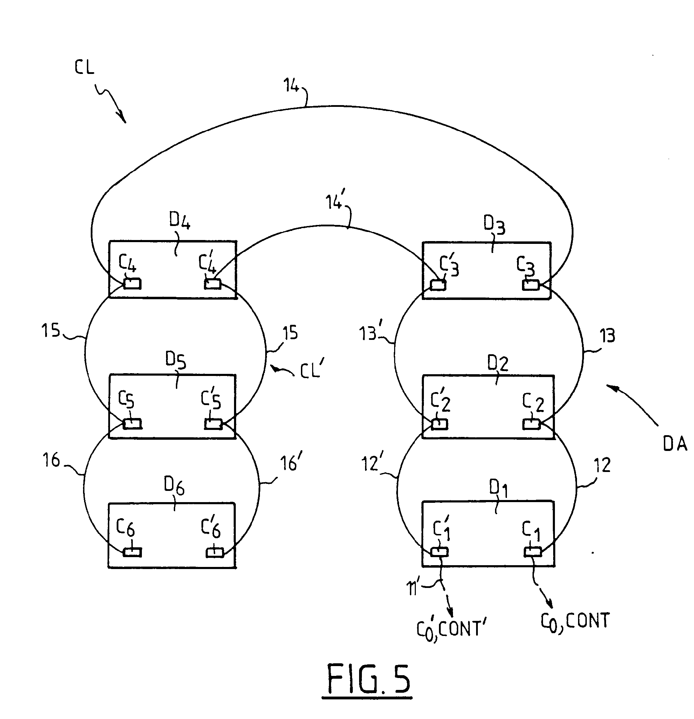

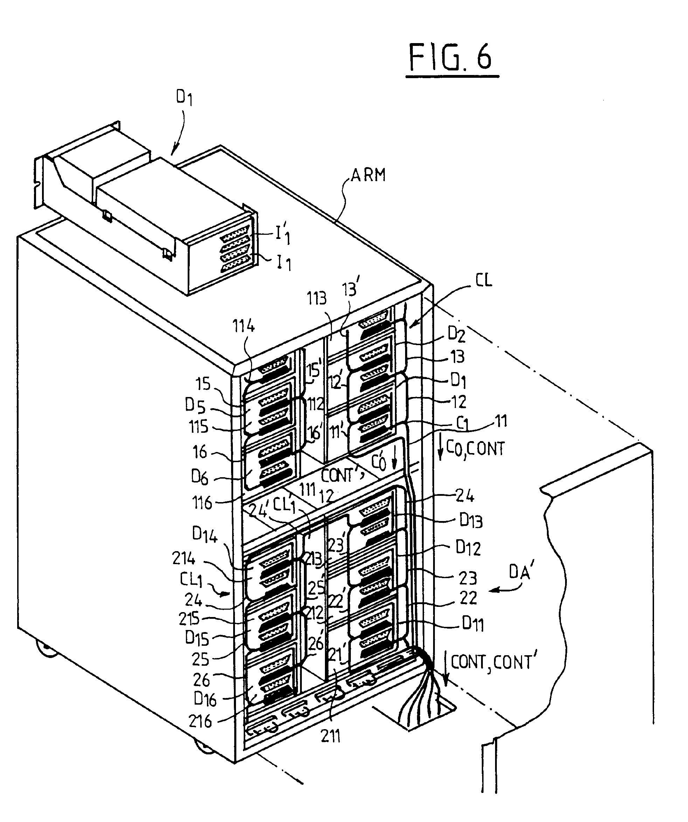

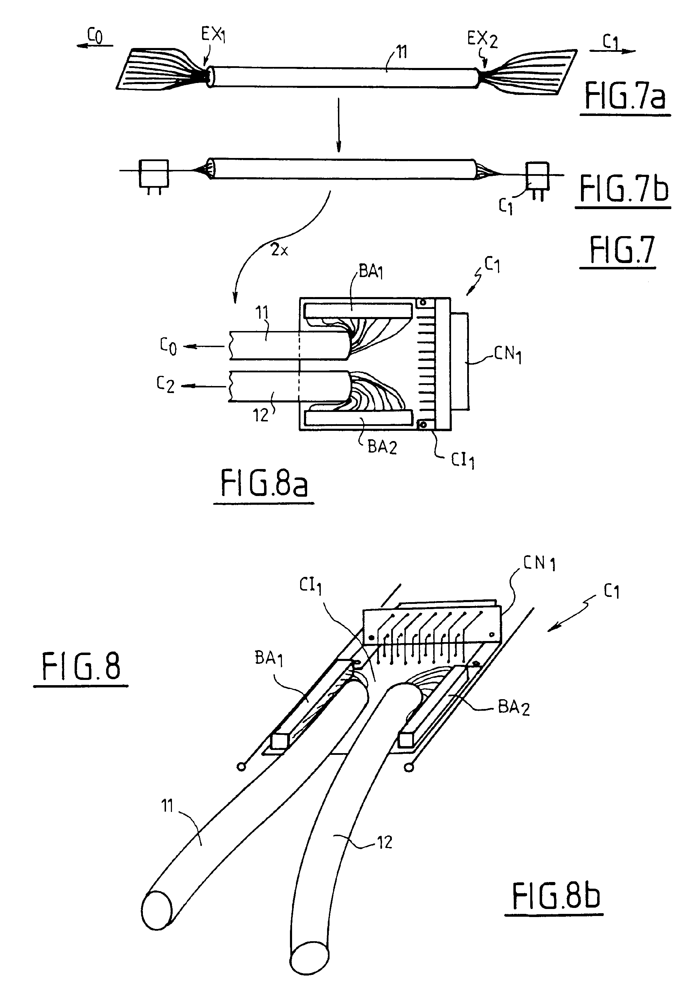

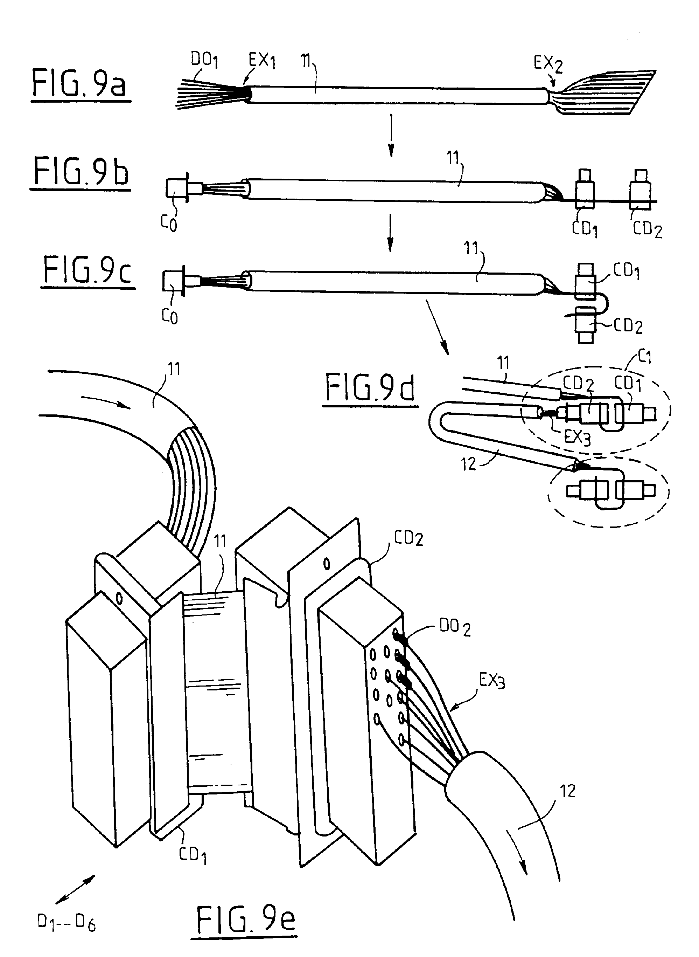

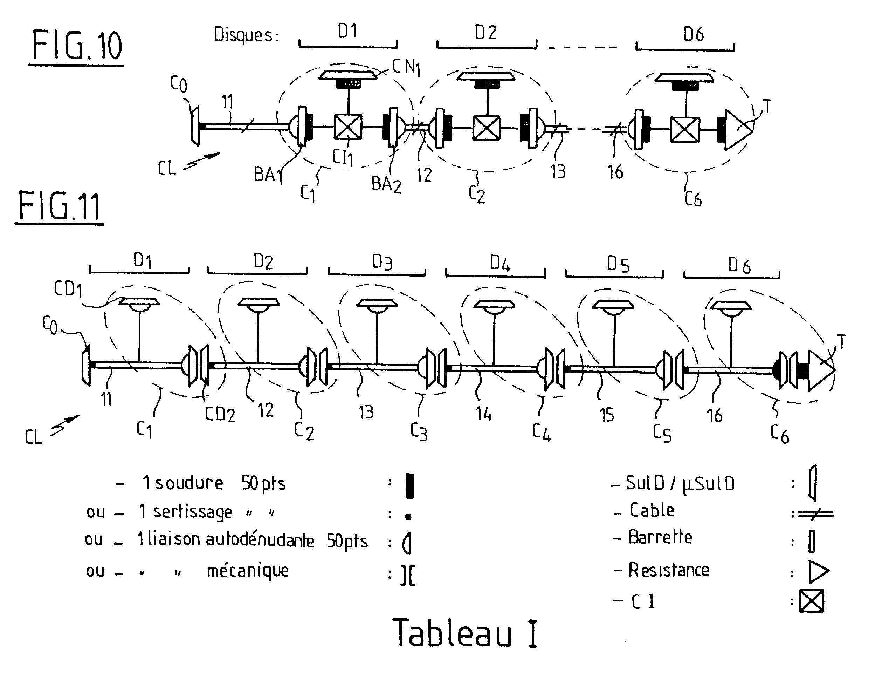

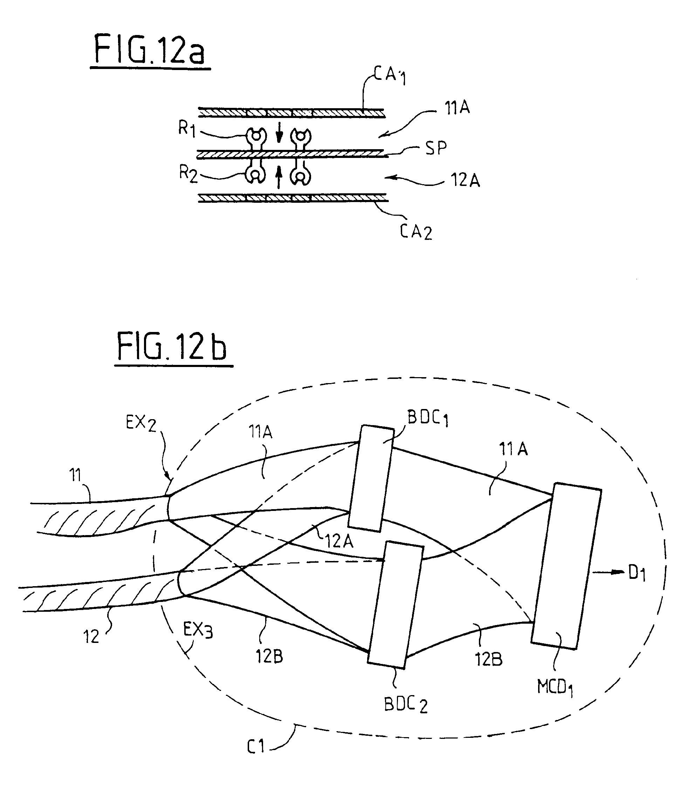

Sur ces dessins :
- ***La*** ***figure*** ***1*** montre un premier exemple d'une chaîne de liaison électrique selon l'art antérieur,
- ***La*** ***figure*** ***2*** montre un second exemple de réalisation d'une chaîne de liaison selon l'art antérieur remédiant partiellement aux inconvénients de celle de la figure 1,
- ***La*** ***figure*** ***3*** composée des figures 3a et 3b montre, sous forme simplifiée une chaîne de liaison selon l'invention,
- ***La figure 4*** est une vue en perspective plus détaillée de la chaîne de liaison selon l'invention montrée à la figure 3,
- ***La*** ***figure*** ***5*** est une vue simplifiée d'un ensemble de mémoires à disques, double accès, reliées entre elles par deux chaînes de liaison selon l'invention,
- ***La*** ***figure*** ***6*** montre une armoire contenant deux ensembles de mémoires à disques tels que celui de la figure 5, montées à l'intérieur de cette armoire,
- ***La*** ***figure*** ***7 et*** ***la*** ***figure*** ***8*** montre comment est constitué un premier exemple de réalisation d'un ensemble de connexion appartenant à une chaîne de liaison selon l'invention,
- ***La*** ***figure*** ***9*** montre comment est constituée une seconde forme de réalisation d'un ensemble de connexion appartenant à une chaîne de liaison selon l'invention,
- ***La*** ***figure*** ***10*** montre, vu de 3/4 en perspective, le mode de réalisation de l'ensemble de connexion montré à la figure 9,
- ***La*** ***figure*** ***10*** ***et*** ***la*** ***figure*** ***11*** montrent deux chaînes de liaison selon l'invention constituées respectivement selon les premier et second exemples de réalisation montrés aux figures 8 et 9,
- ***La*** ***figure*** ***12*** montre un troisième exemple de réalisation d'une chaîne de liaison selon l'invention.

On considère les figures 3 et 4.

La chaîne de liaison selon l'invention CL permet de relier le contrôleur de mémoires à disques CONT aux mémoires à disques D₁ à D₆. Cette chaîne de liaison comprend 6 câbles de liaison 11 à 16, 6 ensembles de connexion C₁ à C₆, et l'ensemble de connexion C₀.

L'ensemble de connexion C₀ permet de connecter la chaîne de liaison CL au contrôleur CONT par l'intermédiaire du connecteur femelle de celui-ci I₀. Comme dans le cas de la figure 1, le contrôleur inclut un terminateur T′.

Les câbles de liaison sont reliés entre eux deux à deux, par l'intermédiaire d'un ensemble de connexion. Ainsi, les câbles 11 et 12 sont reliés par l'intermédiaire de l'ensemble de connexion C₁, les câbles 12 et 13 par l'ensemble de connexion C₂ et ainsi de suite, les câbles 15 et 16 étant reliés par l'ensemble de connexion C₅. L'ensemble de connexion C₆ inclut le terminateur T.

Ainsi, chaque ensemble de connexion C₁ à C₆, non seulement assure la liaison électrique entre deux câbles voisins, mais les rend également solidaires mécaniquement l'un de l'autre. On peut donc définir la chaîne de liaison CL selon l'invention comme un ensemble mécanique unique formé d'une suite de câbles de liaison liés entre eux électriquement et mécaniquement par des ensembles de connexion.

La chaîne de liaison CL relie entre elles les mémoires à disques D₁ à D₆ de la manière suivante : l'ensemble de connexion C₁ est connecté au connecteur femelle I₁ de la mémoire à disques D₁, l'ensemble de connexion C₂ est connecté au connecteur femelle I₂ de la mémoire à disques D₂ et ainsi de suite, l'ensemble de connexion C₆ étant connecté au connecteur femelle I₆ de la mémoire à disques D₆.

On voit aisément, en considérant la figure 3, que la chaîne de liaison selon l'invention CL permet de retirer, voire d'ajouter une mémoire à disques à l'ensemble de mémoires à disques déjà reliées entre elles, sans que les liaisons entre ces dernières soient interrompues. Afin de ne pas perturber les liaisons électriques entre ces différentes mémoires à disques et le contrôleur CONT, lorsque l'on retire ou lorsque l'on rajoute une mémoire à disques aux autres, chaque mémoire à disque a une alimentation électrique indépendante et les différentes liaisons d'interfaces sont différentielles.

On voit par ailleurs que la chaîne de liaison selon l'invention permet de laisser libre les connecteurs de sortie O₁ à O₆ des mémoires à disques D₁ à D₆. On peut même envisager de supprimer ces derniers.

On considère désormais la figure 4 qui montre l'aspect physique extérieur que revêt désormais une chaîne de liaison CL selon l'invention. On peut y voir les câbles 11, 12 et partiellement les câbles 13 et 16 qui sont donc des câbles 25 paires torsadées revêtus de leur gaine de protection, ainsi que les différents connecteurs C₀, C₁, C₂, C₆, dont on ne voit que l'enveloppe extérieure constituée de boîtiers métalliques (en fait constituée d'un assemblage de deux demi boîtiers) qui contiennent les connecteurs électriques du type de ceux qui sont montrés aux figures 8 à 12 et qui seront décrit plus en détail par la suite. Ces boîtiers assurent non seulement la rigidité mécanique de l'ensemble de connexion, mais jouent également un rôle de protection contre les chocs mécaniques et la corrosion.

On considère désormais les figures 5 et 6 qui montrent un ensemble DA de 6 mémoires à disques D₁ à D₆, accessibles par deux contrôleurs différents CONT, CONT′. Un tel ensemble de mémoires à disques est dit ensemble double accès. Il est donc accessible par deux systèmes informatiques différents. Cet ensemble DA comporte deux chaînes de liaison identiques CL, CL′, formées respectivement des câbles de liaison 11 à 16, et 11′ à 16′, ainsi que des ensembles de connexion C₁ à C₆, C′₁ à C′₆, ainsi que des ensembles de connexion C₀ et C′₀ permettant de relier les deux chaînes de liaison selon l'invention CL, CL′ aux deux contrôleurs CONT, CONT′. La chaîne de liaison CL est connectée aux mémoires à disques D₁ à D₆ de la même manière qu'à la figure 3. Par ailleurs, les mémoires à disques D₁ à D₆ étant munies, aux figures 5 et 6 de seconds connecteurs d'entrée I′₁ à I′₆, (on peut voir comment sont disposés les connecteurs I₁ et I′₁ sur l'arrière du bâti de la mémoire à disques de D₁, à la figure 6), la chaîne CL′ relie les différentes mémoires à disques D₁ à D₆ entre elles de la même manière que la chaîne CL relie ces mêmes mémoires à disques entre elles par leurs connecteurs I′₁ à I′₆. Le connecteur C′₁ est donc connecté au connecteur femelle I′₁ de la mémoire à disques D₁, et ainsi de suite. On sait que des ensembles de mémoires à disques double accès tels que DA, permettent d'améliorer la disponibilité des données dans les systèmes informatiques.

La figure 6 montre une armoire ARM contenant respectivement deux ensembles de mémoires à disques double accès, à savoir l'ensemble DA montré à la figure 5, et l'ensemble DA′ identique à DA, comprenant six mémoires à disques D₁₁ à D₁₆ et deux chaînes de liaison CL₁, CL′₁ selon l'invention.

L'ensemble DA est disposé dans la partie supérieure de l'armoire ARM (cette armoire est une armoire par exemple métallique de forme parallélépipédique) alors que l'ensemble DA′ est disposé dans sa partie inférieure.

L'armoire ARM comprend un certain nombre de logements de forme parallélépipédique où peuvent être insérées des mémoires à disques dont le bâti a une forme extérieure parallélépipédique. Ainsi dans sa partie supérieure l'armoire ARM dispose de 6 logements 111 à 116 où peuvent être insérées les mémoires à disques D₁ à D₆, alors que la partie inférieure de l'armoire comprend 6 logements 211 à 216 pouvant respectivement recevoir les mémoires à disques D₁₁ à D₁₆ de l'ensemble DA′. Les logements 111 à 113, 211 à 213 d'une part, 114 à 116, 214 à 216, d'autre part sont situés les uns au-dessus des autres (respectivement dans la partie droite et la partie gauche de ARM).

Ainsi qu'on peut le voir à la figure 6 chacun des câbles 11 à 16, 11′ à 16′ des chaînes de liaison CL, CL′ de l'ensemble DA d'une part, 21 à 26, 21′ à 26′ des chaînes de liaison CL₁, CL′₁ de l'ensemble DA′ est fixé de manière appropriée sur le bâti de l'armoire ARM de telle sorte que chacun des ensembles de connexion C₁ à C₆, C′₁ à C′₆ soit placé au niveau du connecteur femelle I₁ à I₆, I′₁ à I′₆ de l'unité de mémoire à disques D₁ à D₆ auquel il doit être connecté. Ainsi, l'ensemble de connexion C₁ est placé au niveau du connecteur I₁ de la mémoire à disques D₁, l'ensemble C₂ au niveau du connecteur I₂ et ainsi de suite, pour C₃ à C₆, l'ensemble de connexion C′₁ étant placé au niveau du connecteur I′₁ et ainsi de suite. Il est évident que ce qui est écrit ci-dessus est valable pour les ensembles de connexion des chaînes CL₁, CL′₁ et des connecteurs femelles correspondants des mémoires D₁₁ à D₁₆. Aussi, avant d'être équipée de ces mémoires à disques D₁ à D₆ et D₁₁ à D₁₆, l'armoire ARM est prééquipée de ces chaînes de liaison CL, CL′, CL₁, CL′₁. On peut donc monter dans cette armoire autant de mémoires à disques qu'il est nécessaire dans la limite de 12. Il est clair que par exemple, dans la partie inférieure de l'armoire ARM, on peut disposer, à la place des mémoires à disques D₁₁ à D₁₆, le contrôleur CONT sous forme de cartes disposées à l'intérieur d'un panier porte-cartes, ou encore les alimentations des mémoires à disques D₁ à D₆.

La principale difficulté de réalisation d'ensembles de connexion tels que C₁ d'une chaîne de liaison selon l'invention, telle que la chaîne CL tient à ce qu'il n'est pas évident de relier entre eux deux câbles de 25 paires de fils torsadées et par conséquent volumineux, sous forme d'ensembles de connexion, compacts, bon marché, présentant une bonne rigidité mécanique, et présentant dans le temps une excellente fiabilité.

Les trois exemples de réalisation montrés aux figures 7 à 12 se proposent de remplir ces exigences.

On considère désormais la figure 7 et la figure 8.

La figure 8 montre un exemple de réalisation d'un ensemble de connexion tel que C₁ d'une chaîne de liaison CL selon l'invention. La figure 8a est une vue de dessus de cet ensemble de connexion, alors que la figure 8b est une vue de 3/4 en perspective. Les figures 8a et 8b montrent la partie de l'ensemble de connexion qui est située à l'intérieur du boîtier montré, par exemple, à la figure 4.

Un tel ensemble de connexion C₁ comprend un circuit imprimé CI₁ ayant une forme carrée ou rectangulaire, deux barrettes auto-dénudantes BA₁ et BA₂, parallèles l'une à l'autre, par exemple du type 8603 de la Société SOURIAU, et un connecteur CN₁, par exemple de type SubD (par exemple fabriqué par les Sociétés 3 M, AMP, ANSLEY, etc ...). Le connecteur CN₁ est soudé sur l'une des extrémités du circuit imprimé CI₁. Ainsi qu'on peut le voir sur la figure 8a, la longueur du connecteur CN₁ est égale à la dimension du côté du circuit imprimé CI₁, dans le cas où celui-ci est de forme carrée et à la largeur de celui-ci s'il est de forme rectangulaire. Les deux barrettes auto-dénudantes BA₁ et BA₂ sont disposées sur le côté du circuit imprimé perpendiculairement à la longueur du connecteur CN₁. Autrement dit, sur la figure 8a, les deux barrettes auto-dénudantes sont parallèles aux côtés du carré constituant le circuit imprimé CI₁ qui sont horizontaux. Les barrettes auto-dénudantes sont soudées sur le circuit imprimé CI₁. Pour fixer les extrémités des câbles de liaison 11 et 12 sur l'ensemble de connexion C₁, il est nécessaire de mettre à plat les extrémités des 50 fils torsadés qui constituent ces câbles de liaison, ainsi qu'on peut le voir à la figure 7a, où l'on a fait figurer les extrémités EX₁ et EX₂ des 50 fils torsadés constituant le câble 11 (le problème est évidemment identique pour chacun des câbles 11 à 16). Une fois que ces mêmes extrémités sont mises à plat, on insère celles-ci dans les trous correspondants de la barrette auto-dénudante correspondante, par exemple BA₁ pour l'extrémité EX₂, celle-ci étant ensuite soudée sur le circuit imprimé CI₁. Il est clair que c'est le circuit imprimé lui-même, par l'intermédiaire de ses conducteurs internes qui assure la liaison électrique entre les extrémités des 50 fils constituant les câbles 11 et 12 et les 50 points que possède le connecteur CN₁. L'insertion des extrémités des 50 fils du câble 11 dans la barrette auto-dénudante est montrée à la figure 7b, qui est une vue de côté des extrémités EX₁ et EX₂ dans le plan formé par l'ensemble des fils (une fois ceux-ci mis à plat). Ceci explique que l'on ne voie qu'un seul fil sur les 50 à la figure 7b.

On considère la figure 9 qui montre un second exemple de réalisation d'un ensemble de connexion d'une chaîne selon l'invention, supposé être C₁. Seule la partie de l'ensemble de connexion située à l'intérieur d'un boîtier tels que ceux montrés à la figure 4, est montrée aux figures 9d et 9e. Un tel ensemble est formé par l'association de deux connecteurs de type SubD fixés l'un à l'autre en tête-bêche. Le connecteur CD₁ est un connecteur mâle destiné à être connecté au connecteur femelle I₁ du disque D₁, alors que le connecteur CD₂ est un connecteur femelle destiné à être relié au câble 12.

Le câble 11, ainsi qu'on peut le voir aux figures 9d et 9e est connecté à la fois au connecteur CD₁ et au connecteur CD₂. Pour ce faire, l'extrémité EX₂ du câble 11 est d'abord mise à plat (voir figure 9a). Elle est ensuite connectée aux deux connecteurs CD₁ et CD₂, en étant d'abord insérée dans le connecteur CD₁, puis dans le connecteur CD₂ (figure 9b). Pour cela, elle est d'abord connectée au connecteur CD₁ par l'intermédiaire des liaisons autodénudantes de ce dernier. Une fois que l'on a fait passer les fils à travers le connecteur CD₁, on connecte ceux-ci au connecteur CD₂.

Une fois le câble 11 fixé sur l'ensemble de connexion C₁, on fixe l'extrémité EX₃ du câble 12 sur le connecteur femelle CD₂. A cet effet, après avoir détorsadé les fils, les extrémités de ceux-ci sont serties à l'intérieur de petites douilles cylindriques DO₂ (fig. 9e et fig. 9a où l'on peut voir les fils de l'extrémité EX₁ du câble 11 munies de leurs douilles de contacts DO₁). On introduit ensuite, fil par fil, chaque douille dans un trou correspondant de l'extrémité femelle du connecteur CD₂ (voir fig. 9e et également figures 9b et 9c où l'on voit l'extrémité EX₁ du câble 11 introduite dans le connecteur C₀).

Une fois l'extrémité EX₃ du câble 12 sertie dans le connecteur femelle CD₂, on fixe mécaniquement l'un à l'autre les deux connecteurs CD₁ et CD₂ par des moyens appropriés (par exemple, par vissage des deux corps extérieurs des connecteurs). L'ensemble ainsi constitué est ensuite disposé à l'intérieur des boîtiers formant l'enveloppe du connecteur C₁ (se reporter à la figure 4).

On considère les figures 10 et 11 qui montrent respectivement une chaîne de liaison selon l'invention CL réalisée selon le premier et le second mode de réalisation. Chaque ensemble de connexion C₁ à C₆ est montré formé d'un ensemble de symboles représentatifs des différents éléments qui le constituent, ainsi que des modes de liaison entre ces éléments. Toute la symbolique utilisée aux figures 10 et 11 est indiquée sur le tableau 1 qui est joint à ces figures. Ainsi, on peut voir, à la figure 10, par exemple pour l'ensemble de connexion C₁ les deux barrettes auto-dénudantes BA₁ et BA₂, le circuit intégré CI₁, le connecteur CN₁, les trois soudures 50 points qui permettent de relier les deux barrettes auto-dénudantes BA₁ et BA₂ et le connecteur CN₁ au circuit intégré CI₁, ainsi que les liaisons auto-dénudantes 50 points qui permettent de relier respectivement les deux barrettes auto-dénudantes BA₁ et BA₂ aux deux câbles 11 et 12.

L'ensemble de connexion C₆ est identique dans sa plus grande partie aux autres ensembles de connexion C₁ à C₅, à l'exception de l'une des deux barrettes auto-dénudantes qui est remplacée par le terminal adaptateur T qui est par conséquent inséré dans cet ensemble de connexion.

Ainsi qu'on peut le voir à la figure 11, l'ensemble de connexion C₁ comprend les deux connecteurs CD₁ et CD₂ (à la figure 11, le connecteur CD₁ est symbolisé deux fois, puisque le câble 11 est relié d'une part au connecteur CD₂ par l'intermédiaire du connecteur CD₁ et d'autre part est relié vers la sortie du connecteur CD₁, destiné à être connectée au connecteur femelle I₁ de la mémoire à disques D₁).

De même qu'à la figure 10, l'ensemble de connexion C₆ comprend le terminateur T. Chaque ensemble de connexion tel que C₁ comprend donc outre les deux connecteurs CD₁ et CD₂, deux liaisons auto-dénudantes reliant l'extrémité du câble 11 à cet ensemble de connexion et un sertissage qui permet de relier cet ensemble à l'autre câble, à savoir 12 pour l'ensemble de connexion C₁.

On considère la figure 12 qui montre un troisième exemple de réalisation d'un ensemble de connexion tel que C₁, construit autour d'un connecteur MCD₁ de type autodénudant normalisé microsub-D, au pas de 1,27 mn entre les contacts, pouvant être utilisé aussi bien suivant la norme ANSI SCSI que suivant la norme ANSI IPI. (Un tel connecteur est par exemple fabriqué par la Société AMP). Le connecteur MCD₁ est destiné à être connecté au connecteur femelle I₁ de la mémoire à disques D₁.

L'ensemble de connexion C₁ comprend en outre deux barrettes autodénudantes BDC₁ et BDC₂. Chacune de celles-ci est une barrette à 25 doubles contacts permettant de relier entre elles deux nappes de 25 fils. La structure d'une telle barrette à doubles contacts autodénudants est mise en évidence à la figure 12a. Une telle barrette BDC₁ (la structure est évidemment identique pour la barrette BDC₂), qui est vue en coupe suivant un plan parallèle à la grande dimension de la barrette, comprend une première rangée de contacts R₁ et une seconde rangée de contacts R₂ chacune de ces rangées comprenant 25 contacts (deux contacts seulement sont montrés à la figure 12a pour chaque rangée R₁ et R₂, dans un but évident de simplification de la figure). Chaque contact d'une rangée est électriquement relié au contact correspondant de l'autre rangée. Ces deux rangées R₁ et R₂ sont montées sur un support plastique SP, les enveloppes (ou capots) extérieures de la barrette étant désignées par CA₁ et CA₂.

Afin d'être connectée à chacune des barrettes BDC₁ et BDC₂, chaque extrémité EX₂ et EX₃ des câbles 11 et 12, après avoir été mise à plat, est divisée en deux nappes de 25 fils, à savoir les nappes 11A et 11B pour l'extrémité EX₂ du câble 11, 12A et 12B pour l'extrémité EX₃ du câble 12. La première nappe 11A est connectée à la première rangée de contacts R₁. Pour ce faire, selon la technique autodénudante, chacun des 25 fils de la nappe est posé sur chacun des 25 contacts correspondant de la rangée R₁. On sertit ensuite ces 25 fils sur leurs contacts en appuyant le capot CA₁ sur ceux-ci, ce qui permet, dans le même temps de fixer celui-ci, par exemple par encliquetage, sur le support SP. La nappe 11A ayant, pour ainsi dire, traversé la barrette BDC₁, est ensuite connectée, selon une technique analogue, au connecteur MCD₁.

La seconde nappe 12A est ensuite connectée à la seconde rangée de contacts R₂ selon la technique utilisée pour 11A, à cette différence près, que, une fois posés les fils, on coupe ceux-ci au ras des contacts de manière à ce qu'ils ne puissent traverser la barrette. Ainsi, seule la nappe 11A traverse la barrette.

Il est clair que les deux nappes 11B et 12B sont connectées à la barrette BDC₂ de la même manière que 11A et 12A à BDC₁. Seule la nappe 12B traverse la barrette et est connectée au connecteur MDC₁.

On sait que dans les connecteurs 50 points autodénudants de type microsub-D au pas de 1,27 millimètres, la connexion d'un câble s'établit en divisant les 50 fils de celui-ci en deux nappes de 25 fils qui ne traversent pas le connecteur. Le troisième exemple de réalisation de l'ensemble de connexion C₁ selon l'invention, utilisant un tel connecteur permet de résoudre de manière simple et élégante, la connexion de deux câbles ayant chacun 50 fils à un tel connecteur grâce à l'emploi de barrettes autodénudantes doubles contacts.

L'avantage de ce troisième mode de réalisation est d'éviter l'utilisation de soudures et de sertissages. Par ailleurs, elle est extrêmement bon marché.

## Revendications

1. Chaîne de liaison électrique (CL) reliant entre elles une pluralité de au maximum n unités périphériques d'un système de traitement de l'informations (D₁ à D₆) et leur contrôleur associé (CONT) comprenant une suite de n câbles distincts (11 à 16) à plusieurs paires torsadées et un ensemble d'éléments de connexions à plusieurs points (C₁ à C₆) permettant de relier électriquement entre eux les câbles et d'y connecter les unités périphériques, et des terminateurs (T, T′) d'adaptation d'impédance placés aux deux extrémités de la chaîne, la chaîne (CL) formant un ensemble mécanique unique, chaque câble de la suite (11 à 16) étant solidaire mécaniquement de son voisin, au moyen d'un ensemble de connexion (C₁ à C₆), chaque ensemble de connexion étant associé à une unité périphérique, l'un des deux terminateurs étant intégré à l'ensemble de connexion de l'extrémité de la chaîne opposée à l'extrémité raccordée au contrôleur.

2. Mémoire de masse magnétique (DA) comprenant une pluralité d'unités amovibles de mémoires magnétiques (D₁ à D₆) disposées à l'intérieur d'au moins une armoire (ARM) qui comporte d'une part une pluralité de logements (111 à 116) destinés chacun à recevoir une unité de mémoire, comprenant au moins une chaîne de liaison électrique selon la revendication 1 fixée sur le bâti de l'armoire (ARM) au voisinage immédiat des logements (111 à 116) des unités de mémoire (D₁, D₆) de façon que chacun des ensembles de connexion de la chaîne (C₁ à C₆) soit placé au niveau du connecteur (I₁ à I₆) de l'unité de mémoire correspondante,

3. Chaîne de liaison selon la revendication 1, caractérisée en ce que chaque ensemble de connexion (C₁ à C₆) comprend un circuit imprimé (CI₁) sur lequel sont soudés d'une part sur un premier côté un connecteur de type SubD (CN₁) destiné à être connecté au connecteur correspondant d'une unité périphérique, et d'autre part deux barrettes auto-dénudantes (BA₁ et BA₂) sensiblement parallèles sur deux autres côtés opposés de celui-ci, chaque barrette étant reliée aux fils de l'extrémité (EX₂) d'un câble (11) de la suite au moyen d'une liaison auto-dénudante.

4. Chaîne de liaison selon la revendication 1 caractérisé en ce que chaque ensemble de connexion (C₁) comprend un premier et un second connecteur (CD₁, CD₂) mâle et femelle de type SubD reliés respectivement par une liaison auto-dénudante à l'extrémité (EX₂) d'un premier câble (11), le second connecteur étant relié par une autre liaison auto-dénudante aux fils de l'extrémité (EX₃) d'un second câble (12).

5. Chaîne de liaison selon la revendication 1 caractérisée en ce que chaque ensemble de connexion (C₁) comprend un connecteur de type microsub-D autodénudant (MCD₁) associé à deux barrettes doubles contacts autodénudantes (BDC₁, BDC₂), la première et la seconde barrette étant respectivement reliées à une première nappe de fils (11A) du premier câble (11) relié à l'ensemble de connexion, et à une première nappe de fils (12A) du second câble (12) connecté à ce même ensemble de connexion, et à une seconde nappe de fils (11B) du premier câble (11) et une seconde nappe (12B) du second câble (12), les secondes rangées de contact des deux barrettes étant reliées au connecteur (MCD₁) par l'intermédiaire respectivement d'une première nappe de fils (11AB) et d'une seconde nappe de fils (12AB), le nombre de fils des première et seconde nappes reliant les barrettes autodénudantes au connecteur étant égal au nombre total de fils de chacun des câbles reliés à l'ensemble de connexion.

## Claims

1. An electrical connection chain (CL) connecting together a plurality of at most n peripheral units of a data processing system (D₁ to D₆) and their associated controller (CONT) comprising a series of n different cables (11 to 16) with several twisted pairs and an assembly of multipoint connection elements (C₁ to C₆) making it possible to connect the cables together electrically and to connect the peripheral units thereto, and impedance matching terminators (T, T′) placed at both ends of the chain, the chain (CL) forming a single mechanical assembly, each cable in the series (11 to 16) being mechanically integral with its neighbour, by means of a connection assembly (C₁ to C₆), each connection assembly being associated with a peripheral unit, one of the two terminators being incorporated with the connection assembly at the end of the chain, opposite the end connected to the controller.

2. A magnetic bulk memory (DA) comprising a plurality of movable magnetic memory units (D₁ to D₆) arranged inside at least one cabinet (ARM) which comprises on the one hand a plurality of housings (111 to 116) each intended to receive one memory unit, comprising at least one electrical connection chain according to Claim 1 fastened to the frame of the cabinet (ARM) in the immediate vicinity of the housings (111 to 116) of the memory units (D₁, D₆) such that each of the connection assemblies of the chain (C₁ to C₆) is placed on a level with the connector (I₁ to I₆) of the corresponding memory unit.

3. A connection chain according to Claim 1, characterised in that each connection assembly (C₁ to C₆) comprises a printed circuit (CI₁) to which are soldered, on the one hand, on a first side a connector of the SubD type (CN₁) intended to be connected to the corresponding connector of a peripheral unit and, on the other hand, two self-stripping bars (BA₁ and BA₂), substantially parallel, on two other opposite sides of the latter, each bar being connected to the wires at the end (EX₂) of a cable (11) in the series by means of a self-stripping connection.

4. A connection chain according to Claim 1, characterised in that each connection assembly (C₁) comprises a first and a second male and female connector (CD₁, CD₂) of the SubD type connected respectively by a self-stripping connection to the end (EX₂) of a first cable (11), the second connector being connected by another self-stripping connection to the wires at the end (EX₃) of a second cable (12).

5. A connection chain according to Claim 1, characterised in that each connection assembly (C₁) comprises a connector of the self-stripping microsub-D type (MCD₁) associated with two self-stripping double-contact bars (BDC₁, BDC₂), the first and the second bar being respectively connected to a first bundle of wires (11A) of the first cable (11) connected to the connection assembly and to a first bundle of wires (12A) of the second cable (12) connected to this same connection assembly, and to a second bundle of wires (11B) of the first cable (11) and a second bundle (12B) of the second cable (12), the second contact rows of the two bars being connected to the connector (MCD₁) through the intermediary respectively of a first bundle of wires (11AB) and a second bundle of wires (12AB), the number of wires in the first and second bundles connecting the self-stripping bars to the connector being equal to the total number of wires in each of the cables connected to the connection assembly.

## Patentansprüche

1. Elektrische Verbindungskette (CL), die eine Mehrzahl von maximal n Peripherieeinheiten eines Informationsverarbeitungssystems (D₁ bis D₆) und deren zugehörige Steuereinrichtung (CONT) miteinander verbindet, mit einer Folge von n verschiedenen Kabeln (11 bis 16) mit mehreren verdrillten Doppelleitungen und einer Gesamtheit von Mehrpunkt-Anschlußelementen (C₁ bis C₆), die es ermöglichen, die Kabel untereinander elektrisch zu verbinden und an sie die Peripherieeinheiten anzuschließen, und Impedanzanpassungsabschlüssen (T, T'), die an den beiden Enden der Kette angeordnet sind, wobei die Kette (CL) eine einzige mechanische Gesamtheit bildet, wobei jedes Kabel der Folge (11 bis 16) mit seinem Nachbarn mittels einer Anschlußgesamtheit (C₁ bis C₆) mechanisch verbunden ist, wobei die Anschlußgesamtheit mit einer Peripherieeinheit verbunden ist und wobei einer der beiden Abschlüsse in die Anschlußgesamtheit desjenigen Endes der Kette integriert ist, das zu dem mit der Steuereinrichtung verbundenen Ende entgegengesetzt ist.

2. Magnetischer Massenspeicher (DA), mit mehreren abnehmbaren Magnetspeichereinheiten (D₁ bis D₆), die innerhalb wenigstens eines Schranks (ARM) angeordnet sind, der einerseits mehrere Aufnahmesitze (111 bis 116) aufweist, die jeweils dazu bestimmt sind, eine Speichereinheit aufzunehmen, mit wenigstens einer elektrischen Verbindungskette gemäß Anspruch 1, die am Rahmen des Schranks (ARM) in unmittelbarer Umgebung der Aufnahmesitze (111 bis 116) für die Speichereinheiten (D₁, D₆) befestigt ist, so daß sich jede der Anschlußgesamtheiten der Kette (C₁ bis C₆) auf Höhe des Anschlußes (I₁ bis I₆) der entsprechenden Speichereinheit befindet.

3. Verbindungskette gemäß Anspruch 1, dadurch gekennzeichnet, daß jede Anschlußgesamtheit (C₁ bis C₆) eine gedruckte Schaltung (CI₁) umfaßt, auf der einerseits auf einer ersten Seite ein Verbinder vom Typ SubD (CN₁) angelötet ist, der dazu bestimmt ist, mit dem entsprechenden Verbinder einer Peripherieeinheit verbunden zu werden, und auf der andererseits an zwei weiteren Seiten, die der ersten gegenüberliegen, zwei selbstabisolierende Stege (BA₁ und BA₂) im wesentlichen parallel angelötet sind, wobei der Steg mit den Drähten des Endes (EX₂) eines Kabels (11) der Folge mittels einer selbstabisolierenden Verbindung verbunden sind.

4. Verbindungskette gemäß Anspruch 1, dadurch gekennzeichnet, daß jede Anschlußgesamtheit (C₁) einen ersten und einen zweiten Steck- und Buchsenverbinder (CD₁, CD₂) vom Typ SubD umfaßt, die jeweils über eine selbstabisolierende Verbindung mit dem Ende (EX₂) eines ersten Kabels (11) verbunden sind, wobei der zweite Verbinder über eine weitere selbstabisolierende Verbindung mit den Drähten des Endes (EX₃) eines zweiten Kabels (12) verbunden ist.

5. Verbindungskette gemäß Anspruch 1, dadurch gekennzeichnet, daß die Anschlußgesamtheit (C₁) einen Verbinder des Typs selbstabisolierender Mikrosub-D (MCD₁) umfaßt, der mit zwei selbstabisolierenden Doppelkontaktstegen (BDC₁, BDC₂) verbunden ist, wobei der erste und der zweite Steg jeweils mit einem ersten Drahtgewebe (11A) des ersten Kabels (11), das mit der Anschlußgesamtheit verbunden ist, mit einem ersten Drahtgewebe (12A) des zweiten Kabels (12), das mit derselben Anschlußgesamtheit verbunden ist, sowie mit einem zweiten Drahtgewebe (11B) des ersten Kabels (11) und mit einem zweiten Gewebe (12B) des zweiten Kabels (12) verbunden sind, wobei die zweiten Reihen von Kontakten der zwei Stege über ein erstes Drahtgewebe (11AB) bzw. ein zweites Drahtgewebe (12AB) mit dem Verbinder (MCD₁) verbunden sind, wobei die Anzahl der Drähte des ersten Gewebes und des zweiten Gewebes, die die selbstabisolierenden Stege mit dem Verbinder verbinden, gleich der Gesamtzahl der Drähte eines jeden der Kabel ist, die mit der Anschlußgesamtheit verbunden sind.
